# EUROPÄISCHE PATENTSCHRIFT

(11) **EP 3 494 770 B1**
(45) Veröffentlichungstag und Bekanntmachung des Hinweises auf die Patenterteilung: **17.06.2020**
(21) Anmeldenummer: 18185638.6
(22) Anmeldetag: 26.07.2018
(51) Int. Cl.: A01D 41/127

(54) **VERFAHREN FÜR DEN BETRIEB EINER SELBSTFAHRENDEN LANDWIRTSCHAFTLICHEN ARBEITSMASCHINE**
METHOD FOR OPERATING A SELF-PROPELLED AGRICULTURAL WORKING MACHINE
PROCÉDÉ DE FONCTIONNEMENT D'UN ENGIN AGRICOLE AUTOMATIQUE

(30) Priorität: 29.09.2017 DE 102017122710
(43) Veröffentlichungstag der Anmeldung: 12.06.2019
(73) Patentinhaber: CLAAS E-Systems GmbH, 49201 Dissen am Teutoburger Wald (DE)
(72) Erfinder: Neitemeier, Dennis, 59510 Lippetal (DE); Kettelhoit, Boris, 33335 Gütersloh (DE); Krause, Thilo, 39249 Glinde (DE); Skiba, Andreas, 33647 Bielefeld (DE)

(56) Entgegenhaltungen:
- DE-A1-102015 116 586
- US-A1- 2003 184 747
- GIULIO REINA ET AL: "Towards Autonomous Agriculture: Automatic Ground Detection Using Trinocular Stereovision", SENSORS, Bd. 12, Nr. 12, 12. September 2012 (2012-09-12), Seiten 12405-12423, XP055401661, DOI: 10.3390/s120912405

## Beschreibung

Die Erfindung betrifft ein Verfahren für den Betrieb einer selbstfahrenden landwirtschaftlichen Arbeitsmaschine gemäß dem Obergriff von Anspruch 1 sowie eine solche selbstfahrende Arbeitsmaschine gemäß Anspruch 9.

Der Begriff "selbstfahrende landwirtschaftliche Arbeitsmaschine" ist vorliegend weit zu verstehen. Darunter fallen nicht nur Erntemaschinen, wie Mähdrescher und Feldhäcksler, sondern auch Zugmaschinen, wie Traktoren oder dergleichen.

Bei dem Betrieb einer in Rede stehenden, selbstfahrenden landwirtschaftlichen Arbeitsmaschine kommt der sensorbasierten Überwachung des Umfelds der Arbeitsmaschine zunehmende Bedeutung zu. Dadurch, dass das Umfeld der Arbeitsmaschine nicht in standardisierter, sensorisch leicht erfassbarer Form vorliegt, sondern vielmehr in gewissen Grenzen eine nicht deterministische Struktur aufweist, stellt die sensorbasierte Erfassung von vorbestimmten Eigenschaften des Umfelds der Arbeitsmaschine eine Herausforderung dar.

Das bekannte Verfahren (DE 10 2015 116 586 A1), von dem die Erfindung ausgeht, sieht in einer Variante eine Sensoranordnung vor, die ein kamerabasiertes Sensorsystem und ein laserbasiertes Sensorsystem aufweist. Dabei werden Eigenschaften des Umfelds basierend auf den Sensorinformationen dieser beiden Sensorsysteme erfasst. Während sich durch die Sensorfusion eine zuverlässige Erfassung der jeweiligen Eigenschaften des Umfelds ergibt, steckt in der Übersichtlichkeit der Darstellung der jeweils erfassten Eigenschaften noch Optimierungspotential. Ferner ist bei dem bekannten Verfahren eine steuerungsseitige Reaktion auf eine erfasste Umfeldeigenschaft nicht trivial, da sich der richtige Zeitpunkt für die Reaktion aufgrund der perspektivischen Ansicht auf die Feldebene nur schwer vorhersagen lässt.

Der Erfindung liegt das Problem zugrunde, das bekannte Verfahren derart auszugestalten und weiterzubilden, dass die Darstellung der jeweils erfassten Eigenschaften intuitiver und eine steuerungsseitige Reaktion auf erfasste Umfeldeigenschaften vereinfacht ist.

Das obige Problem wird bei einem Verfahren gemäß dem Oberbegriff von Anspruch 1 durch die Merkmale des kennzeichnenden Teils von Anspruch 1 gelöst.

Wesentlich ist die grundsätzliche Überlegung, die jeweils erfassten Eigenschaften des Umfelds nicht durch eine perspektivische Ansicht auf die Feldebene, die sich aus der Anordnung des kamerabasierten Sensorsystems an der Arbeitsmaschine ergibt, sondern durch eine Draufsicht auf die Feldebene zu repräsentieren.

Im Einzelnen wird zunächst vorgeschlagen, dass die Sensorinformationen der Sensorsysteme von einem Sensorfusionsmodul fusioniert werden, indem zur Erzeugung eines fusionierten Bildes Sensorinformationen des laserbasierten Sensorsystems in die Ausgangs-Kamerabilder eingebracht werden. Wesentlich ist dabei, dass die fusionierten Bilder derart verzerrt werden, dass sie jeweils eine Draufsicht auf die Feldebene repräsentieren.

Mit den verzerrten fusionierten Bildern lässt sich die Maschine auf besonders einfache Weise steuern, da sich die Arbeitsmaschine in der realen Umgebung mit gleicher Annäherungsgeschwindigkeit an die jeweiligen Umfeldeigenschaften annähert wie im verzerrten fusionierten Bild. Die Ermittlung des richtigen Zeitpunkts für das Auslösen der betreffenden Steueraktion ist damit unproblematisch.

Das vorschlagsgemäße Verzerren von Bildern zur Änderung der Perspektive wird auch als "Warping" bezeichnet und ist vom Grundsatz her aus dem Bereich der Bildverarbeitung bekannt. Insoweit darf beispielsweise auf die deutsche Patentanmeldung DE 10 2016 118 227.3 verwiesen werden, die auf die Anmelderin zurückgeht und deren Inhalt insoweit zum Gegenstand der vorliegenden Anmeldung gemacht wird.

Die Änderung der Perspektive eines Bildes durch Verzerren ist mit geringem Rechenaufwand möglich. Dabei wird eine eingeschränkte Vollständigkeit in der Darstellung solcher Merkmale des Bildes in Kauf genommen, die im Ausgangs-Kamerabild verdeckt sind.

Bei der bevorzugten Ausgestaltung gemäß Anspruch 2 ist es so, dass das Fahrerassistenzsystem zumindest einen Teil der Arbeitsorgane basierend auf den verzerrten fusionierten Bildern parametriert und/oder ansteuert. Dies trägt dem Umstand Rechnung, dass eine automatisierte Ansteuerung mit der vorschlagsgemäßen Lösung aufgrund einer einfachen zeitlichen Synchronisierung entsprechend einfach möglich ist. Entsprechend wird in Anspruch 3 vorgeschlagen, dass das Fahrerassistenzsystem zumindest einen Teil der Arbeitsorgane der Arbeitsmaschine zeitlich synchronisiert mit der Fahrgeschwindigkeit der Arbeitsmaschine und den zeitlichen Änderungen in den verzerrten fusionierten Bildern parametriert oder ansteuert.

Bei der besonders bevorzugten Ausgestaltung gemäß Anspruch 4 ist eine vorrausschauende Erzeugung von Steueraktion durch das Fahrerassistenzsystem vorgesehen. Das geht auf die einfache Ermittlung der Annäherungsgeschwindigkeit der Arbeitsmaschine an eine vorbestimmte Umfeldeigenschaft zurück.

Bei der bevorzugten Ausgestaltung gemäß Anspruch 5 weist das Fahrerassistenzsystem ein Bildverarbeitungssystem zur Verarbeitung der Kamerabilder auf, wobei die Kamerabilder von dem Bildverarbeitungssystem nach einer Segmentierungsvorschrift in Bildsegmente segmentiert werden. Dabei basiert die Sensorfusion darin, dass zumindest einem Teil der Bildsegmente jeweils durch Sensorinformationen des laserbasierten Sensorsystems, hier durch Höheninformationen, angereichert werden. Dies kann gemäß Anspruch 6 vorzugsweise dadurch erfolgen, dass die Klassifizierung der Bildsegmente unter Berücksichtigung der Sensorinformationen des laserbasierten Sensorsystems vorgenommen wird. Die Klassifizierung eines Bildsegments entspricht hier der oben angesprochenen Ermittlung einer Umfeldeigenschaft.

Bei dem laserbasierten Sensorsystem handelt es sich vorzugsweise um ein Sensorsystem, bei dem die Sensorinformationen bezogen auf die Feldebene Höheninformationen sind. Die Feldebene ist die Ebene, entlang der sich der relevante Umfeldbereich erstreckt. Im Allgemeinen handelt es sich hierbei um die horizontale Ebene, sofern der relevante Umfeldbereich keine Steigung gegenüber der horizontalen Ebene aufweist. Mittels des laserbasierten Sensorsystems lässt sich also die Höhe des Bestands, die Höhe von Hindernissen oder dergleichen erfassen.

Für die Klasseneigenschaft zur Definition einer obigen Klasse sind ganz verschiedene vorteilhafte Möglichkeiten denkbar. Beispielsweise ist die Klasseneigenschaft einer Klasse durch die Existenz zu erntenden Gutbestands definiert. Denkbar ist auch, dass die Klasseneigenschaft einer Klasse durch die Existenz eines lebenden oder eines nicht lebenden Hindernisses definiert ist.

Die ebenfalls bevorzugten Ausgestaltungen gemäß den Ansprüchen 7 und 8 betreffen vorteilhafte Steueraktionen des Fahrerassistenzsystems. Beispielsweise kann es gemäß Anspruch 7 vorgesehen sein, dass eine Steueraktion die Ausgabe des verzerrten fusionierten Bilds über die Mensch-Maschine-Schnittstelle des Fahrerassistenzsystems ist. Alternativ oder zusätzlich kann in Abhängigkeit von der Lage der klassifizierten Bildsegmente die Ausgabe einer Warnmeldung über die Mensch-Maschine-Schnittstelle vorgesehen sein. Bei der besonders bevorzugten Ausgestaltung gemäß Anspruch 8 führt das Fahrerassistenzsystem selbsttätig eine Notroutine durch, sofern ein klassifiziertes Bildsegment ein Hindernis im zukünftigen Fahrweg der Arbeitsmaschine repräsentiert. Im einfachsten Fall handelt es sich bei der Notroutine um eine Stopproutine zum Anhalten der Arbeitsmaschine.

Nach einer weiteren Lehre gemäß Anspruch 9, der eigenständige Bedeutung zukommt, wird eine selbstfahrende landwirtschaftliche Arbeitsmaschine als solche zur Durchführung eines vorschlagsgemäßen Verfahrens beansprucht. Auf alle Ausführungen, die geeignet sind, die Arbeitsmaschine als solche zu beschreiben, darf verwiesen werden.

Es darf noch darauf hingewiesen werden, dass der Begriff "Bild" vorliegend stets eine Datenstruktur repräsentiert, die über eine Mensch-Maschine-Schnittstelle bildgebend darstellbar ist, nicht jedoch dargestellt sein muss.

Im Folgenden wird die Erfindung anhand einer lediglich ein Ausführungsbeispiel darstellenden Zeichnung näher erläutert. In der Zeichnung zeigt
- Fig. 1: eine vorschlagsgemäße selbstfahrende landwirtschaftliche Arbeitsmaschine in einer Ansicht von oben,
- Fig. 2: das Fahrerassistenzsystem der Arbeitsmaschine gemäß Fig. 1 in einer ganz schematischen Darstellung,
- Fig. 3: einen beispielhaften Ablauf einer vorschlagsgemäßen Sensorfusion bei einer Arbeitsmaschine gemäß Fig. 1 und
- Fig. 4: einen beispielhaften Ablauf eines vorschlagsgemäßen Verzerrens eines fusionierten Bildes.

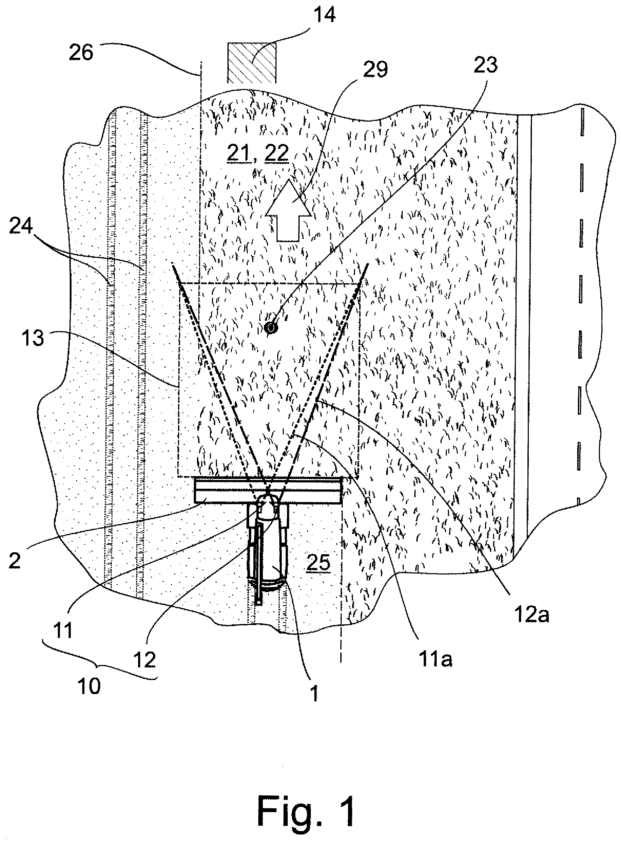

Die vorschlagsgemäße Lösung lässt sich auf einen weiten Bereich selbstfahrender landwirtschaftlicher Arbeitsmaschinen anwenden. Dazu gehören Mähdrescher, Feldhäcksler, Zugmaschinen, insbesondere Traktoren oder dergleichen. Bei dem dargestellten und insoweit bevorzugten Ausführungsbeispiel handelt es sich bei der Arbeitsmaschine 1 um einen Mähdrescher, der in an sich üblicher Weise mit einem Vorsatzgerät 2 ausgestattet ist. Die Arbeitsmaschine 1 von oben zeigt Fig. 1 während des Ernteprozesses.

Die vorschlagsgemäße Arbeitsmaschine 1 ist mit mindestens einem Arbeitsorgan 3-8 ausgestattet. Eine als Mähdrescher ausgestaltete Arbeitsmaschine 1 weist vorzugsweise die Arbeitsorgane Fahrantrieb 3, Schneidwerk 4, Dreschwerk 5, Abscheidevorrichtung 6, Reinigungsvorrichtung 7 und Verteilvorrichtung 8 auf.

Die Arbeitsmaschine 1 ist ferner mit einem Fahrerassistenzsystem 9 zum Erzeugen von Steueraktionen innerhalb der Arbeitsmaschine 1 ausgestattet. Die Steueraktionen können einerseits die Anzeige von Informationen für den Benutzer und andererseits die Ansteuerung und Parametrierung der Arbeitsorgane 3-8 betreffen.

Weiter ist der Arbeitsmaschine 1 eine Sensoranordnung 10 zur Erzeugung von Umfeldinformationen zugeordnet, wobei das Fahrerassistenzsystem 9 die Steueraktionen basierend auf den Umfeldinformationen erzeugt. Die Sensoranordnung 10 weist ein kamerabasiertes Sensorsystem 11 und ein laserbasiertes Sensorsystem 12 auf, die jeweils Sensorinformationen zu einem vorbestimmten, relevanten Umfeldbereich 13 der Arbeitsmaschine 1 erzeugen, dem eine Feldebene 14 zugeordnet ist. In dem darstellten und insoweit bevorzugten Ausführungsbeispiel ist der relevante Umfeldbereich 13 als Vorfeldbereich der Arbeitsmaschine 1 vorbestimmter Form und Größe definiert. Die Sensorsysteme 11, 12 sind jeweils an der Arbeitsmaschine 1, vorzugsweise in einer gegenüber der Feldebene 14 erhöhten Position, angeordnet.

Vorzugsweise ist es vorgesehen, dass sich die Erfassungsbereiche 11a, 12a der beiden Sensorsysteme 11, 12 überlappen. Die Sensorinformationen des kamerabasierten Sensorsystems 11 liegen als zeitliche Folge von Ausgangs-Kamerabildern 15 vor, die je nach Anwendungsfall vorverarbeitet sein können. Die Ausgangs-Kamerabilder 15 werden von dem Kamera-Sensorsystem 11 laufend, vorzugsweise zyklisch, erzeugt und entsprechend sequenziell in noch zu erläuternder, vorschlagsgemäßer Weise bearbeitet.

Das kamerabasierte Sensorsystem weist vorzugsweise mindestens eine Kamera, insbesondere mindestens eine Farbbildkamera, zur Erzeugung der Ausgangs-Kamerabilder 14 auf. Bei der Kamera kann es sich um eine 2D-Kamera oder um eine 3D-Kamera handeln. Das laserbasierte Sensorsystem 12 ist vorzugsweise mit mindestens einem abstandsmessenden Lasersensor, insbesondere Laserscanner, ausgestattet. In besonders bevorzugter Ausgestaltung weist das laserbasierte Sensorsystem 12 mindestens einen LIDAR-Sensor auf.

Der Begriff "perspektivische Ansicht" ist im Hinblick auf die Ausgangs-Kamerabilder 15 vorliegend so zu verstehen, dass das kamerabasierte Sensorsystem 11 aufgrund seiner Anordnung an der Arbeitsmaschine 1 stets schräg von oben auf die Feldebene 14 gerichtet ist.

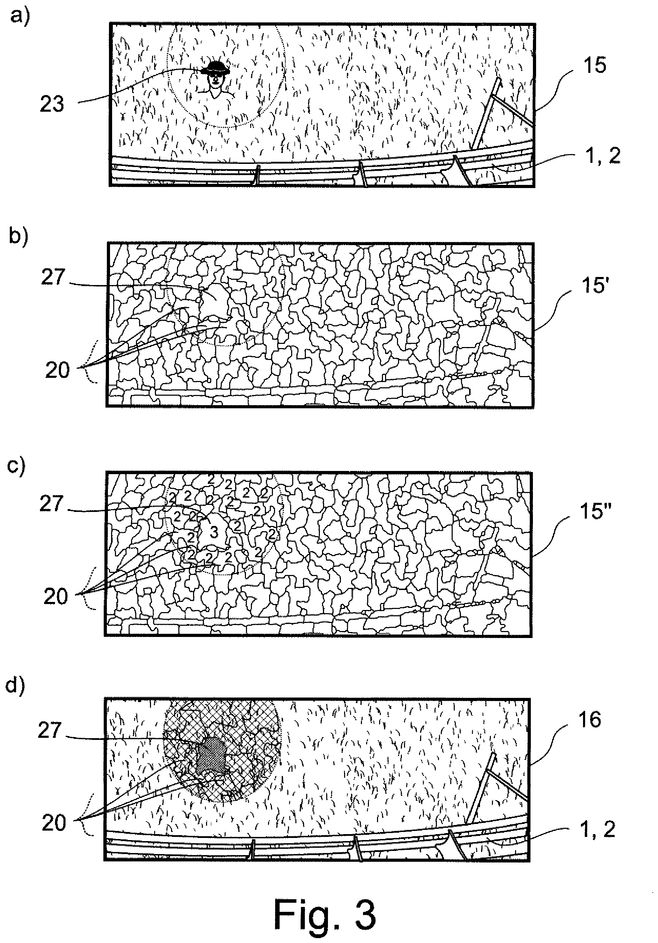

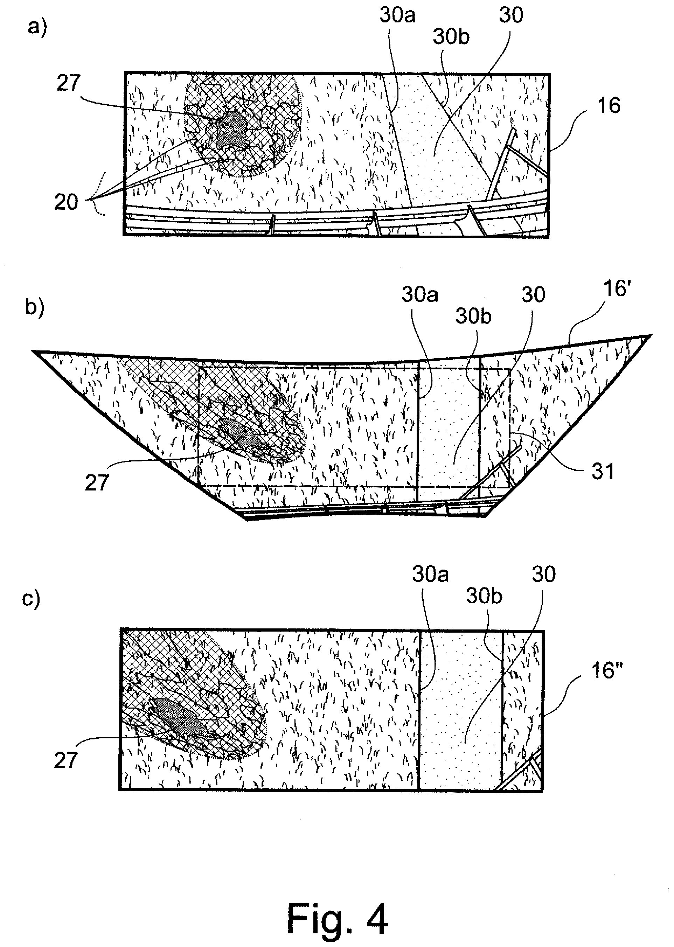

Wesentlich ist nun, dass die Sensorinformationen der beiden Sensorsysteme 11, 12 fusioniert werden, indem zur Erzeugung fusionierter Bilder Sensorinformationen des laserbasierten Sensorsystems 12 in die Ausgangs-Kamerabilder 15 eingebracht werden, was in der noch zu erläuternden Darstellung gemäß Fig. 3 gezeigt ist. Wesentlich ist weiter, dass die fusionierten Bilder 16 derart verzerrt werden, dass sie jeweils eine Draufsicht auf die Feldebene 14 repräsentieren, was in der noch zu erläuternden Darstellung gemäß Fig. 4 gezeigt ist.

Vorzugsweise werden die verzerrten fusionierten Bilder 16' von dem Fahrerassistenzsystem 9 genutzt, um die Arbeitsorgane 3-6, insbesondere das Schneidwerk 4, automatisiert zu parametrieren und/oder anzusteuern.

Im Einzelnen ist es vorzugsweise vorgesehen, dass das Fahrerassistenzsystem 9 zumindest einen Teil der Arbeitsorgane 3-7, insbesondere ein Schneidwerk 4, der Arbeitsmaschine 1 basierend auf den verzerrten fusionierten Bildern 16' durch entsprechende Steueraktionen parametriert und/oder ansteuert. Dabei kann es insbesondere vorgesehen sein, dass das Fahrerassistenzsystem 9 zumindest einen Teil der Arbeitsorgane 3-7 der Arbeitsmaschine 1 zeitlich synchronisiert mit der Fahrgeschwindigkeit der Arbeitsmaschine 1 und den zeitlichen Änderungen in den verzerrten fusionierten Bildern 16' durch entsprechende Steueraktionen parametriert oder ansteuert.

Ganz besonders vorteilhaft bei der vorschlagsgemäßen Lösung ist die Tatsache, dass das Fahrerassistenzsystem 9 die Steueraktionen nunmehr mit geringem Rechenaufwand vorausschauend durchführen kann, wie weiter oben ausgeführt worden ist. Vorzugsweise ist es hierfür vorgesehen, dass das Fahrerassistenzsystem 9 aus den zeitlichen Änderungen in den verzerrten fusionierten Bildern 16' eine Annäherungsgeschwindigkeit der Arbeitsmaschine 1 an eine vorbestimmte Umfeldeigenschaft ermittelt und dass das Fahrerassistenzsystem 9 zumindest einen Teil der Arbeitsorgane 3-7 in Abhängigkeit von der Umfeldeigenschaft, insbesondere bevor die Arbeitsmaschine 1 die Umfeldeigenschaft erreicht, parametriert und/oder ansteuert.

Ein Beispiel für eine automatisierte Parametrierung und/oder Ansteuerung der Arbeitsorgane 3-8 der Arbeitsmaschine 1 ist eine Veränderung im Bestand, beispielsweise in der Veränderung der Höhe des Bestands, die eine entsprechende Anpassung der Parametrierung des Schneidwerks 4 erfordert. Strategien für eine solche Anpassung sind grundsätzlich bekannt.

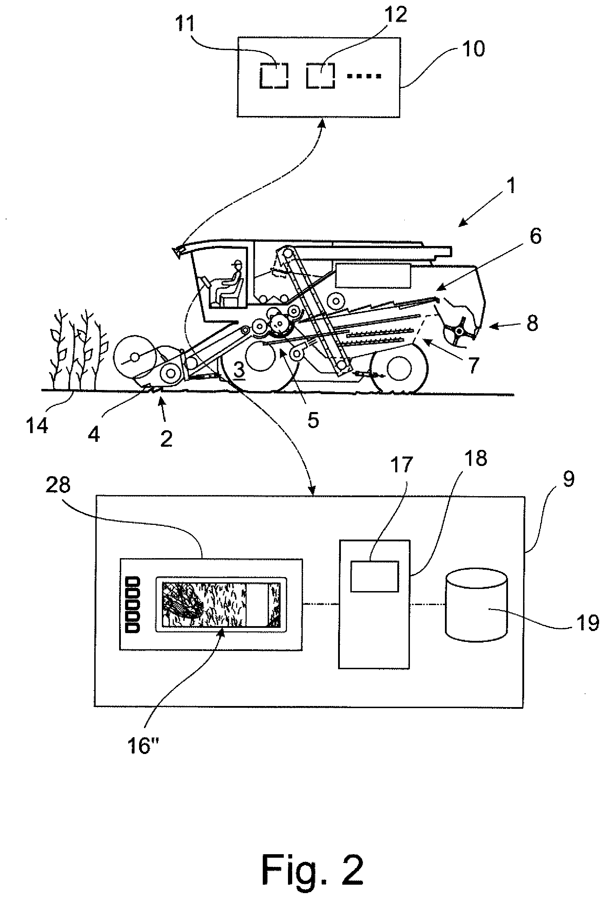

Für die Sensorfusion bestehen zahlreiche Möglichkeiten der Umsetzung. Hier und vorzugsweise weist das Fahrerassistenzsystem 9 ein Bildverarbeitungssystem 17 zur Verarbeitung der Ausgangs-Kamerabilder 15 auf. In besonders bevorzugter Ausgestaltung wird das Bildverarbeitungssystem 17 von einer Rechenvorrichtung 18 des Fahrerassistenzsystems 9 bereitgestellt, die mit einer digitalen Datenspeichereinheit 19 datentechnisch gekoppelt ist (Fig. 2). Vorschlagsgemäß werden die Ausgangs-Kamerabilder 15 (Fig. 3a)) von dem Bildverarbeitungssystem 17 nach einer Segmentierungsvorschrift in Bildsegmente 20 segmentiert. Für die Segmentierungsvorschrift sind je nach Anwendungsfall unterschiedliche Varianten vorteilhaft. Beispielsweise kann die Segmentierung basierend auf der Farbverteilung über das jeweilige Ausgangs-Kamerabild vorgenommen werden. Hinsichtlich bevorzugter Verfahren zur Segmentierung wird auf die deutsche Patentanmeldung DE 10 2016 118 227.3 verwiesen, die auf die Anmelderin zurückgeht und deren Inhalt insoweit zum Gegenstand der vorliegenden Anmeldung gemacht wird.

Zusätzlich zu dem Bildverarbeitungssystem 17 oder integriert in das Bildverarbeitungssystem 17 ist ein Sensorfusionsmodul vorgesehen, wobei die segmentierten Kamerabilder 15' (Fig. 3b)) von dem Sensorfusionsmodul mit den Sensorinformationen des laserbasierten Sensorsystems 12 fusioniert werden. Ein derart fusioniertes Kamerabild 15" ist in Fig. 3c) angedeutet.

Hier und vorzugsweise handelt es sich bei den Sensorinformationen des laserbasierten Sensorsystems 12 um Höheninformationen, die auf die Feldebene 14 bezogen sind. Dabei ist das laserbasierte Sensorsystem 12 vorzugsweise mit mindestens einem, oben angesprochenen, laserbasierten LIDAR-Sensor ausgestattet.

Fig. 3c) zeigt für einen Bildausschnitt, dass im Rahmen der Sensorfusion zumindest einem Teil der Bildsegmente 20 jeweils genau eine Höheninformation zugeordnet wird. Die Höheninformation ist hier und vorzugsweise aus den Sensorinformationen des laserbasierten Sensorsystems 12 für das Umfeldsegment im relevanten Umfeldbereich13, das zu dem jeweiligen Bildsegment 20 korrespondiert, abgeleitet worden. Dabei kann es grundsätzlich auch vorgesehen sein, dass einem Bildsegment 20 mehr als eine Höheninformation, insbesondere mehrere Höheninformationen, zugeordnet sind. Bei der hier und vorzugsweise einzigen Höheninformation eines Bildsegments 20 kann es sich beispielsweise um den Maximalwert aller zu dem korrespondierenden Umfeldsegment erfasster Höheninformationen oder um deren Mittelwert handeln. In Fig. 3c) sind die Höheninformationen jeweils als Zahlenwert angedeutet.

In einem nächsten Verfahrensschritt ist es vorzugsweise vorgesehen, dass die Bildsegmente 20 von dem Bildverarbeitungssystem 17 nach einer Klassifizierungsvorschrift in Klassen mit Klasseneigenschaften klassifiziert werden, so dass den Bildsegmenten 20 jeweils eine Klasse zugeordnet wird. Wesentlich dabei ist, dass nicht nur die Charakteristik des betreffenden Bildsegments 20, sondern auch die Sensorinformationen des laserbasierten Sensorsystems 12 bei der Klassifizierung berücksichtigt werden. Durch die zusätzliche Berücksichtigung der Sensorinformationen des laserbasierten Sensorsystems 12 ergibt sich eine besonders hohe Reproduzierbarkeit bei der Klassifizierung der Bildsegmente 20. Die Klassifizierung entspricht vorliegend der Erfassung einer oben angesprochenen Umfeldeigenschaft, die durch das Bildsegment und die zugeordnete Klasse repräsentiert wird.

Die Klassifizierungsvorschrift kann auch vorsehen, dass bei der Klassifizierung eines Bildsegments 20 die umliegenden Bildsegmente berücksichtigt werden. Damit kann beispielsweise bei der Klassifizierung eines Bildsegments als "lebendes Hindernis" genutzt werden, dass ein lebendes Hindernis, zumindest eine Person, regelmäßig eine Spur im Bestand verursacht, die in der hier vorliegenden Zeichnung allerdings nicht dargestellt ist.

Alternativ oder zusätzlich kann es vorgesehen sein, dass das kamerabasierte Sensorsystem 11 zyklisch Kamerabilder erzeugt und dass bei der Klassifizierung eines Bildsegments 20 die Sensorinformationen der beiden Sensorsysteme 11, 12 zu vorangegangenen Kamerabildern berücksichtigt werden. Dabei ist es vorzugsweise so, dass auch das laserbasierte Sensorsystem 12 seine Sensorinformationen zyklisch erzeugt, so dass zu jedem Kamerabild entsprechende Sensorinformationen des laserbasierten Sensorsystems 12 vorliegen.

Die in der Klassifizierungsvorschrift enthaltene Klasseneigenschaft einer Klasse kann in unterschiedlicher Weise definiert sein. In einer bevorzugten Variante ist die Klasseneigenschaft einer Klasse durch die Existenz zu erntenden Gutbestands 21 definiert. Alternativ oder zusätzlich ist die Klasseneigenschaft einer Klasse durch die Existenz stehenden Gutbestands 22 definiert. Alternativ oder zusätzlich ist die Klasseneigenschaft einer Klasse durch die Existenz eines lebenden Hindernisses 23 definiert. Alternativ oder zusätzlich ist die Klasseneigenschaft einer Klasse durch die Existenz eines nicht lebenden Hindernisses definiert. Alternativ oder zusätzlich ist die Klasseneigenschaft einer Klasse durch die Existenz einer Fahrgasse 24 definiert. Alternativ oder zusätzlich ist die Klasseneigenschaft einer Klasse durch die Existenz eines abgeernteten Bereichs 25 definiert. Alternativ oder zusätzlich ist die Klasseneigenschaft einer Klasse schließlich durch die Existenz einer Bestandskante 26 definiert. Der beispielhafte Ablauf gemäß den Fig. 3 und 4 ist auf die Situation gerichtet, in der sich in dem relevanten Umfeldbereich 13 ein lebendes Hindernis 23, hier eine Person, befindet. Die Person 23 ist in Fig. 3a) zu erkennen.

Im Rahmen der vorschlagsgemäßen Segmentierung kommt hier und vorzugsweise der in Fig. 3a) gezeigten Person 23 ein in Fig. 3b) gezeigtes Bildsegment 27 zu, das gemäß Fig. 3c) im Rahmen der Sensorfusion mit der Höheninformation "3" versehen sind, während die umgebenden Bildsegmente 18 mit der Höheninformation "2" versehen sind. Dabei steht die Höheninformation "3" für eine größere Höhe als die Höheninformation "2".

Im Rahmen der Klassifizierung wird aus Faktoren wie der Form, des Volumens oder der Farbe des Segments 27 in Verbindung mit dem Faktor der Höheninformation "3" darauf geschlossen, dass das Bildsegment 27 der Klasse eines Hindernisses zuzurechnen ist. Sofern sich aus der Folge der Kamerabilder zusätzlich eine in der Klassifizierungsvorschrift festgelegte, räumliche Fluktuation des Bildsegments 27 ergibt, kann dem Bildsegment 27 die Klasse "lebendes Hindernis" zugeordnet werden. Andere Beispiele für die Ermittlung der Klasse eines Bildsegments 20 sind denkbar.

Eine besonders übersichtliche Darstellung ergibt sich bereits dadurch, dass in dem fusionierten Bild 16 die Bildsegmente 20 in Abhängigkeit von der jeweils zugeordneten Klasse und/oder in Abhängigkeit von den jeweils zugeordneten Sensorinformationen des laserbasierten Sensorsystems 12 farblich unterschiedlich dargestellt sind. Anstelle unterschiedlicher Farbe können auch unterschiedliche Schraffierungen oder dergleichen genutzt werden.

Ferner kann es vorgesehen sein, dass in dem jeweiligen fusionierten Bild eine selektive Anzeige von Bildsegmenten 20 vorgenommen wird, dass also beispielsweise Bildsegmente 20 vorbestimmter Klassen in dem fusionierten Bild nicht enthalten sind.

Das Fahrerassistenzsystem 9 kann die Ergebnisse des vorschlagsgemäßen Verfahrens in unterschiedlicher Weise verwenden. Vorzugsweise ist es vorgesehen, dass das Fahrerassistenzsystem 9 eine Mensch-Maschine-Schnittstelle 28 aufweist, wobei eine Steueraktion die Ausgabe des verzerrten Bilds 16 über die Mensch-Maschine-Schnittstelle 28 ist. Alternativ oder zusätzlich kann es vorgesehen sein, dass in Abhängigkeit von den klassifizierten Bildsegmenten 20, insbesondere in Abhängigkeit von der Lage der klassifizierten Bildsegmente 20, die Ausgabe einer Warnmeldung über die Mensch-Maschine-Schnittstelle 28 als Steueraktion ausgegeben wird.

Bei einem höheren Automatisierungsgrad der Arbeitsmaschine 1 ist es denkbar, dass für den Fall, dass die klassifizierten Bildsegmente 20 im zukünftigen Fahrweg 29 der Arbeitsmaschine 1 ein Hindernis repräsentieren, die Steueraktion des Fahrerassistenzsystems 9 die Durchführung einer Notroutine ist. Bei dieser Notroutine kann es sich um eine Stopproutine zum Anhalten der Arbeitsmaschine 1 und/oder um eine Ausweichroutine zum Ausweichen der Arbeitsmaschine 1 vordem Hindernis handeln.

Die Darstellung gemäß Fig. 4 zeigt nun das vorschlagsgemäße Verzerren des jeweiligen fusionierten Bilds 16, ausgehend von der in Fig. 3d) gezeigten Situation.

Zur Verdeutlichung des vorschlagsgemäßen Verzerrens ist das in Fig. 3d) und Fig. 4a) gezeigte, fusionierte Bild 16 um eine gerade Schneise 30, die durch den Bestand verläuft, erweitert worden.

Die vorschlagsgemäße Verzerrung des fusionierten Bilds 16 ergibt sich aus dem Übergang von Fig. 4a) auf 4b). Diese Verzerrung kann nach verschiedenen Regeln erfolgen. Beispielsweise kann es vorgesehen sein, dass die Verzerrung iterativ solange durchgeführt wird, bis solche Kanten, die in der Realität parallel zueinander sind, auch in dem verzerrten fusionierten Bild 16' parallel erscheinen. Dies lässt sich anhand der Kanten 30a), 30b) der Schneise 30 leicht nachvollziehen.

Alternativ können bei dem vorschlagsgemäßen Verzerren des fusionierten Bilds 16 die Sensorinformationen des laserbasierten Sensorsystems 12 herangezogen werden. Beispielsweise können durch eine Abstandsmessung des laserbasierten Sensorsystems 12 vier Punkte eines gedachten Quadrats in der Feldebene 14 im Hinblick auf den Abstand zu einem Referenzpunkt des laserbasierten Sensorsystems 12 vermessen werden. Aus diesen Abstandswerten, der Lage des laserbasierten Sensorsystems 12 zu dem kamerabasierten Sensorsystem 11 sowie aus der optischen Charakteristik des kamerabasierten Sensorsystems 11 lassen sich diese Punkte des Quadrats ohne Weiteres an den entsprechenden Positionen im fusionierten Bild 16 anordnen. Die Verzerrung wird dann so vorgenommen, dass sich im verzerrten fusionierten Bild 16' wieder ein Quadrat ergibt. Schließlich folgt noch der Zuschnitt des verzerrten fusionierten Bilds 16' in eine Schablone 31, so dass sich das resultierende Bild 16" ergibt.

Der Darstellung gemäß Fig. 4c) lässt sich entnehmen, dass sich Steueraktionen, die einen autonomen Eingriff des Fahrerassistenzsystems 9 in den Arbeitsprozess, insbesondere in die Fahrsteuerung der Arbeitsmaschine 1, betreffen, auf einfache Weise rechnergestützt vornehmen lassen. Dies ohne die Notwendigkeit rechenaufwändiger Koordinatentransformationen oder dergleichen. Damit ist es möglich, diese Steueraktionen im laufenden Arbeitsbetrieb, insbesondere in Echtzeit, automatisiert zu generieren.

Nach einer weiteren Lehre, der eigenständige Bedeutung zukommt, wird die selbstfahrende landwirtschaftliche Arbeitsmaschine 1 zur Durchführung eines oben erläuterten, vorschlagsgemäßen Verfahrens als solche beansprucht. Auf alle diesbezüglichen Ausführungen darf verwiesen werden.

In besonders bevorzugter Ausgestaltung ist es vorgesehen, dass das Fahrerassistenzsystem 9, wie oben angesprochen, eine Rechenvorrichtung 18 aufweist, die das oben beschriebene Bildverarbeitungssystem 17 bereitstellen kann. Alternativ oder zusätzlich kann es vorgesehen sein, dass das Sensorfusionsmodul von dem Fahrerassistenzsystem 9 der Arbeitsmaschine 1, insbesondere von der Rechenvorrichtung 18, bereitgestellt wird.

Alternativ ist es denkbar, dass zumindest ein Teil des Bildverarbeitungssystems 17 und/oder zumindest ein Teil des Sensorfusionsmoduls auf einem Rechner realisiert ist, der separat von der Arbeitsmaschine 1, insbesondere bei einem Lohndienstleister oder dergleichen, betrieben wird.

Zusammenfassend lässt sich feststellen, dass mit der vorschlagsgemäßen Lösung die erfassten Eigenschaften des relevanten Umfeldbereichs 13 der Arbeitsmaschine 1 mit geringem Aufwand erzeugt und steuerungstechnisch genutzt werden können, wobei die Darstellung des resultierenden Bilds 16" als Draufsicht auf die Feldebene 14 eine besonders intuitive Darstellung auch komplexer Feldstrukturen ermöglicht.

### Bezugszeichenliste

- 1: Arbeitsmaschine
- 2: Vorsatzgerät
- 3-8: Arbeitsorgan
- 9: Fahrerassistenzsystem
- 10: Sensoranordnung
- 11: kamerabasiertes Sensorsystem
- 12: laserbasiertes Sensorsystem
- 13: relevanter Umfeldbereich
- 14: Feldebene
- 15: Ausgangs-Kamerabilder
- 16: fusionierte Bilder
- 17: Bildverarbeitungssystem
- 18: Rechenvorrichtung
- 19: Speichereinheit
- 20: Bildsegmente
- 21: zu erntender Gutbestand
- 22: stehender Gutbestand
- 23: lebendes Hindernis
- 24: Fahrgasse
- 25: abgeernteter Bereich
- 26: Bestandskante
- 27: Segment Hindernis
- 28: Mensch-Maschine-Schnittstelle
- 29: Fahrweg
- 30: Schneise
- 31: Schablone

## Patentansprüche

1. Verfahren für den Betrieb einer selbstfahrenden landwirtschaftlichen Arbeitsmaschine (1) mit mindestens einem Arbeitsorgan (3-8) und mit einem Fahrerassistenzsystem (9) zum Erzeugen von Steueraktionen innerhalb der Arbeitsmaschine (1), wobei eine Sensoranordnung (10) zur Erzeugung von Umfeldinformationen vorgesehen ist, wobei das Fahrerassistenzsystem (9) die Steueraktionen basierend auf den Umfeldinformationen erzeugt, wobei die Sensoranordnung (10) ein kamerabasiertes Sensorsystem (11) und ein laserbasiertes Sensorsystem (12) aufweist, die jeweils Sensorinformationen zu einem vorbestimmten, relevanten Umfeldbereich (13) der Arbeitsmaschine (1) erzeugen, dem eine Feldebene (14) zugeordnet ist,
wobei die Sensorinformationen des kamerabasierten Sensorsystems (11) als zeitliche Folge von Ausgangs-Kamerabildern (15) vorliegen, die jeweils eine perspektivische Ansicht auf die Feldebene (14) repräsentieren,
**dadurch gekennzeichnet,**
**dass** die Sensorinformationen der beiden Sensorsysteme (11, 12) fusioniert werden, indem zur Erzeugung fusionierter Bilder Sensorinformationen des laserbasierten Sensorsystems (12) in die Ausgangs-Kamerabilder (15) eingebracht werden und dass die fusionierten Bilder (16) derart verzerrt werden, dass sie jeweils eine Draufsicht auf die Feldebene (14) repräsentieren.

2. Verfahren nach Anspruch 1, **dadurch gekennzeichnet, dass** das Fahrerassistenzsystem (9) zumindest einen Teil der Arbeitsorgane (3-7), insbesondere ein Schneidwerk (4), der Arbeitsmaschine (1) basierend auf den verzerrten fusionierten Bildern (16') parametriert und/oder ansteuert.

3. Verfahren nach Anspruch 1 oder 2, **dadurch gekennzeichnet, dass** das Fahrerassistenzsystem (9) zumindest einen Teil der Arbeitsorgane (3-7) der Arbeitsmaschine (1) zeitlich synchronisiert mit der Fahrgeschwindigkeit der Arbeitsmaschine (1) und den zeitlichen Änderungen in den verzerrten fusionierten Bildern (16') parametriert oder ansteuert.

4. Verfahren nach einem der vorhergehenden Ansprüche, **dadurch gekennzeichnet, dass** das Fahrerassistenzsystem (9) aus den zeitlichen Änderungen in den verzerrten fusionierten Bildern (16') eine Annäherungsgeschwindigkeit der Arbeitsmaschine (1) an eine vorbestimmte Umfeldeigenschaft ermittelt und dass das Fahrerassistenzsystem (9) zumindest einen Teil der Arbeitsorgane (3-7) in Abhängigkeit von der Umfeldeigenschaft, insbesondere bevor die Arbeitsmaschine (1) die Umfeldeigenschaft erreicht, parametriert und/oder ansteuert.

5. Verfahren nach einem der vorhergehenden Ansprüche, **dadurch gekennzeichnet, dass** das Fahrerassistenzsystem (9) ein Bildverarbeitungssystem (17) zur Verarbeitung der Ausgangs-Kamerabilder (15) aufweist, dass die Ausgangs-Kamerabilder (15) von dem Bildverarbeitungssystem (17) nach einer Segmentierungsvorschrift in Bildsegmente (20) segmentiert werden und dass im Rahmen der Sensorfusion zumindest einem Teil der Bildsegmente (20) jeweils mindestens eine, vorzugsweise genau eine, Höheninformation zugeordnet wird, die aus den Sensorinformationen des laserbasierten Sensorsystems (12) für das Umfeldsegment, das zu dem jeweiligen Bildsegment (20) korrespondiert, abgeleitet werden.

6. Verfahren nach einem der vorhergehenden Ansprüche, **dadurch gekennzeichnet, dass** die Bildsegmente (20) von dem Bildverarbeitungssystem (17) nach einer Klassifizierungsvorschrift in Klassen mit Klasseneigenschaften klassifiziert werden, so dass den Bildsegmenten (20) jeweils eine Klasse zugeordnet wird, und dass die Sensorinformationen des laserbasierten Sensorsystems (12) bei der Klassifizierung berücksichtigt werden und dass bei der Klassifizierung eines Bildsegments (20) die umliegenden Bildsegmente berücksichtig werden, und/oder, dass das kamerabasierte Sensorsystem (11) zyklisch Kamerabilder erzeugt und dass bei der Klassifizierung eines Bildsegments die Sensorinformationen der beiden Sensorsysteme (11, 12) zu vorangegangenen Kamerabildern berücksichtigt werden.

7. Verfahren nach einem der vorhergehenden Ansprüche, **dadurch gekennzeichnet, dass** das Fahrerassistenzsystem (9) eine Mensch-Maschine-Schnittstelle (28) aufweist und dass eine Steueraktion die Ausgabe des verzerrten fusionierten Bilds über die Mensch-Maschine-Schnittstelle (28) und/oder in Abhängigkeit der klassifizierten Bildsegmente die Ausgabe einer Warnmeldung über die Mensch-Maschine-Schnittstelle (28) ist.

8. Verfahren nach einem der vorhergehenden Ansprüche, **dadurch gekennzeichnet, dass** für den Fall, dass die klassifizierten Bildsegmente im zukünftigen Fahrweg (29) der Arbeitsmaschine (1) ein Hindernis repräsentieren, die Steueraktion des Fahrerassistenzsystems (9) die Durchführung einer Notroutine ist, vorzugsweise, dass die Notroutine eine Stopproutine zum Anhalten der Arbeitsmaschine (1) und/oder eine Ausweichroutine zum Ausweichen der Arbeitsmaschine (1) vordem Hindernis umfasst.

9. Selbstfahrende landwirtschaftliche Arbeitsmaschine, **dadurch gekennzeichnet, dass** die Arbeitsmaschine zur Durchführung eines Verfahrens nach einem der vorhergehenden Ansprüche vorgesehen und eingerichtet ist.

## Claims

1. A method of operating a self-propelled agricultural working machine (1) having at least one working member (3-8) and a driver assist system (9) for producing control actions within the working machine (1), wherein there is provided a sensor arrangement (10) for producing environs information, wherein the driver assist system (9) produces the control actions based on the environs information, wherein the sensor arrangement (10) has a camera-based sensor system (11) and a laser-based sensor system (12) which respectively produce sensor information relating to a predetermined relevant environs region (13) of the working machine (1), with which a field plane (14) is associated,
wherein the sensor information of the camera-based sensor system (11) is present as a chronological sequence of output camera images (15) which respectively represent a perspective view on to the field plane (14),
**characterised in that**
the sensor information of the two sensor systems (11, 12) is fused by sensor information of the laser-based sensor system (12) being introduced into the output camera images (15) to produce fused images and the fused images (16) are distorted in such a way that they respectively represent a plan view on to the field plane (14).

2. A method according to claim 1 **characterised in that** the driver assist system (9) parameterises and/or actuates at least a part of the working members (3-7), in particular a cutting mechanism (4), of the working machine (1) based on the distorted fused images (16').

3. A method according to claim 1 or claim 2 **characterised in that** the driver assist system (9) parameterises or actuates at least a part of the working members (3-7) of the working machine (1) in time-synchronised relationship with the travel speed of the working machine (1) and the changes in time in the distorted fused images (16').

4. A method according to one of the preceding claims **characterised in that** the driver assist system (9) ascertains from the changes in time in the distorted fused images (16') an approach speed of the working machine (1) to a predetermined environs property and the driver assist system (9) parameterises and/or actuates at least a part of the working members (3-7) in dependence on the environs property, in particular before the working machine (1) reaches the environs property.

5. A method according to one of the preceding claims **characterised in that** the driver assist system (9) has an image processing system (17) for processing the output camera images (15), the output camera images (15) are segmented by the image processing system (17) in accordance with a segmenting specification into image segments (20) and that in the process of sensor fusion there is respectively associated with at least a part of the image segments (20) at least one and preferably precisely one item of height information which is derived from the sensor information of the laser-based sensor system (12) for the environs segment that corresponds to the respective image segment (20).

6. A method according to one of the preceding claims **characterised in that** the image segments (20) are classified by the image processing system (17) in accordance with a classification specification in classes with class properties so that a respective class is associated with the image segments (20) and the sensor information of the laser-based sensor system (12) is taken into account in the classification process and that in the classification of an image segment (20) the surrounding image segments are taken into account and/or the camera-based sensor system (11) cyclically produces camera images and in the classification of an image segment the sensor information of the two sensor systems (11, 12) are taken into account in relation to preceding camera images.

7. A method according to one of the preceding claims **characterised in that** the driver assist system (9) has a man-machine interface (28) and that a control action is the output of the distorted fused image by way of the man-machine interface (28) and/or in dependence on the classified image segments is the output of a warning message by way of the man-machine interface (28).

8. A method according to one of the preceding claims **characterised in that** in the situation where the classified image segments represent an obstacle in the future travel path (29) of the working machine (1) the control action of the driver assist system (9) is the implementation of an emergency routine, and preferably the emergency routine includes a stop routine for stopping the working machine (1) and/or a diversion routine for diverting the working machine (1) from the obstacle.

9. A self-propelled agricultural working machine **characterised in that** the working machine is provided and adapted to carry out a method according to one of the preceding claims.

## Revendications

1. Procédé d'exploitation d'une machine de travail agricole automotrice (1) comprenant au moins un organe de travail (3-8) et comprenant un système d'assistance au conducteur (9) pour générer des actions de commande à l'intérieur de la machine de travail (1), un agencement de capteur (10) étant prévu pour générer des informations d'environnement, le système d'assistance au conducteur (9) générant les actions de commande sur la base des informations d'environnement, l'agencement de capteur (10) comportant un système de capteur à caméra (11) et un système de capteur à laser (12) qui génèrent respectivement des informations de capteur sur une zone d'environnement pertinente prédéterminée (13) de la machine de travail (1) à laquelle est associé un plan de champ (14), les informations de capteur du système de capteur à caméra (11) se présentant sous la forme d'une suite temporelle d'images de caméra de sortie (15) qui représentent respectivement une vue perspective du plan de champ (14), **caractérisé en ce que** les informations de capteur des deux systèmes de capteur (11, 12) sont fusionnées par le fait que, pour générer des images fusionnées, des informations de capteur du système de capteur à laser (12) sont introduites dans les images de caméra de sortie (15), et **en ce que** les images fusionnées (16) sont déformées de façon qu'elles représentent respectivement une vue de dessus du plan de champ (14) .

2. Procédé selon la revendication 1, **caractérisé en ce que** le système d'assistance au conducteur (9) paramètre et/ou commande une partie des organes de travail (3-7), en particulier un tablier de coupe (4), de la machine de travail (1) sur la base des images déformées fusionnées (16').

3. Procédé selon la revendication 1 ou 2, **caractérisé en ce que** le système d'assistance au conducteur (9) paramètre ou commande au moins une partie des organes de travail (3-7) de la machine de travail (1) de façon temporellement synchronisée avec la vitesse de marche de la machine de travail (1) et avec les variations temporelles dans les images déformées fusionnées (16')

4. Procédé selon une des revendications précédentes, **caractérisé en ce que** le système d'assistance au conducteur (9) détermine, à partir des variations temporelles dans les images déformées fusionnées (16'), une vitesse d'approche de la machine de travail (1) par rapport à une propriété d'environnement prédéterminée, et **en ce que** le système d'assistance au conducteur (9) paramètre et/ou commande au moins une partie des organes de travail (3-7) en fonction de la propriété d'environnement, en particulier avant que la machine de travail (1) n'atteigne la propriété d'environnement.

5. Procédé selon une des revendications précédentes, **caractérisé en ce que** le système d'assistance au conducteur (9) comporte un système de traitement d'image (17) pour traiter les images de caméra de sortie (15), **en ce que** les images de caméra de sortie (15) sont segmentées en segments d'image (20) par le système de traitement d'image (17) selon une consigne de segmentation, et **en ce que**, dans le cadre de la fusion de capteur, à au moins une partie des segments d'image (20) est associée respectivement au moins une, de préférence exactement une, information de hauteur qui est déduite des informations de capteur du système de capteur à laser (12) pour le segment d'environnement qui correspond au segment d'image respectif (20).

6. Procédé selon une des revendications précédentes, **caractérisé en ce que** les segments d'image (20) sont classifiés par le système de traitement d'image (17), selon une consigne de classification, en classes avec des propriétés de classe, de façon qu'aux segments d'image (20) soit associée respectivement une classe, et **en ce que** les informations de capteur du système de capteur à laser (12) sont prises en compte lors de la classification, et **en ce que**, lors de la classification d'un segment d'image (20), les segments d'image environnants sont pris en compte, et/ou **en ce que** le système de capteur à caméra (11) génère cycliquement des images de caméra, et **en ce que**, lors de la classification d'un segment d'image, les informations de capteur des deux systèmes de capteur (11, 12) relatives à des images de caméra précédentes sont prises en compte.

7. Procédé selon une des revendications précédentes, **caractérisé en ce que** le système d'assistance au conducteur (9) comporte une interface homme-machine (28), et **en ce qu'**une action de commande est l'affichage de l'image déformée fusionnée par l'intermédiaire de l'interface homme-machine (28) et/ou, en fonction des segments d'image classifiés, l'affichage d'un message d'alerte par l'intermédiaire de l'interface homme-machine (28).

8. Procédé selon une des revendications précédentes, **caractérisé en ce que** pour le cas où les segments d'image classifiés représentent un obstacle sur le trajet de déplacement à venir (29) de la machine de travail (1), l'action de commande du système d'assistance au conducteur (9) est l'exécution d'une routine d'urgence, de préférence, **en ce que** la routine d'urgence inclut une routine d'arrêt pour mettre la machine de travail (1) à l'arrêt et/ou une routine d'évitement pour que la machine de travail (1) évite l'obstacle.

9. Machine de travail agricole automotrice, **caractérisée en ce que** la machine de travail est prévue et agencée pour réaliser un procédé selon une des revendications précédentes.
